# EUROPÄISCHE PATENTSCHRIFT

(11) **EP 2 572 814 B1**
(45) Veröffentlichungstag und Bekanntmachung des Hinweises auf die Patenterteilung: **30.03.2016**
(21) Anmeldenummer: 11007634.6
(22) Anmeldetag: 20.09.2011
(51) Int. Cl.: B22F 1/00, B23K 35/02, B23K 35/36, H01L 21/48

(54) **Paste und Verfahren zum Verbinden von elektronischem Bauelement mit Substrat**
Paste and method for connecting electronic components with a substrate
Pâte et procédé de connexion d'un composant électronique doté d'un substrat

(43) Veröffentlichungstag der Anmeldung: 27.03.2013
(73) Patentinhaber: Heraeus Deutschland GmbH & Co. KG, 63450 Hanau (DE)
(72) Erfinder: Schäfer, Michael, 36093 Künzell (DE); Schmitt, Wolfgang, 63110 Rodgau (DE); Heilmann, Albert, 63755 Alzenau (DE); Nachreiner, Jens, 63571 Gelnhausen (DE)
(74) Vertreter: Heraeus IP

(56) Entgegenhaltungen:
- WO-A1-2008/000349
- DE-A1- 2 246 827
- DE-A1-102005 053 553
- DE-A1-102009 040 078
- GB-A- 2 380 964
- US-A- 5 281 281
- US-A1- 2003 168 123
- US-A1- 2006 011 267

## Beschreibung

Die vorliegende Erfindung betrifft eine Sinterpaste zum Verbinden eines elektronischen Bauelements mit einem Substrat und ein Verfahren zum Verbinden eines elektronischen Bauelements mit einem Substrat.

Im Bereich der Leistungselektronik stellt das Befestigen von elektronischen Bauelementen auf Substraten eine besondere Herausforderung dar.

So erfordern die im Betrieb des Endgerätes auftretenden mechanischen Beanspruchungen, dass die Verbindung zwischen dem elektronischen Bauelement und dem Substrat eine hinreichend hohe Festigkeit aufweist, so dass sich das elektronische Bauelement von dem Substrat nicht löst. Bisher wurden daher für die Verbindungstechnik bleihaltige Lotpasten eingesetzt, die beim Lötprozess Verbindungsschichten erzeugen, die eine hohe Zuverlässigkeit im Hinblick auf die Festigkeit zeigen. Aufgrund der Toxizität von Blei und den damit verbundenen gesundheitsgefährdenden Risiken wird für diese bleihaltigen Lotpasten jedoch ein geeigneter Ersatz gesucht. Die derzeit als Alternative für Bleilote diskutierten bleifreien Lotpasten sind geeignet, Verbindungsschichten zwischen elektronischen Bauelementen und Substraten mit hoher Festigkeit zu schaffen. Allerdings weisen diese Lote niedrige Schmelzpunkte auf, die nicht weit oberhalb der Temperaturen liegen, denen die elektronischen Bauelemente beim Betrieb ausgesetzt sind. Dies führt dazu, dass beim Betrieb der elektronischen Bauelemente die Verbindungsschichten erheblich an Zuverlässigkeit im Hinblick auf die Festigkeit einbüßen.

Eine hohe Zuverlässigkeit bezüglich der Festigkeit der Verbindung zwischen dem elektronischen Bauelement und dem Substrat lässt sich mit vielen Fügemitteln und Fügeverfahren erreichen. Diese erfordern jedoch oft hohe Prozesstemperaturen und hohe Prozessdrücke, die zu Schädigungen der zu verbindenden Teile führen und beim Massendurchsatz eine hohe Ausschlussrate erzeugen.

Aus diesem Grund gibt es das Bestreben, die für die Fügeverfahren erforderlichen Prozesstemperaturen und Prozessdrücke zu senken. Für einige Anwendungen werden daher zum Verbinden dieser Teile Klebstoffe verwendet. Mit Klebstoffen können zum Teil hohe Festigkeiten der Verbindungsschicht zwischen dem elektronischen Bauelement und dem Substrat erreicht werden. Nachteilig bei der Klebetechnik ist jedoch, dass die geschaffenen Kontaktstellen zwischen dem elektronischen Bauelement und dem Substrat bezüglich der Wärmeleitfähigkeit und der elektrische Leitfähigkeit oft unzureichend sind.

Um die Anforderungen im Hinblick auf die Zuverlässigkeit sowie die Wärmeleitfähigkeit und die elektrische Leitfähigkeit der Fügestelle zu erfüllen, wird seit einiger Zeit vorgeschlagen, elektronische Bauelemente und Substrate durch Sintern miteinander zu verbinden (siehe zum Beispiel DE 10 2007 046 901 A1 oder DE 102009040078 A1). Die Sintertechnik stellt ein sehr einfaches Verfahren zum stabilen Verbinden von Bauelementen dar. Mit diesen Sinterverfahren gelingt es üblicherweise sehr gut, elektronische Bauelemente mit Substraten zu verbinden, wenn diese jeweils einen edelmetallhaltigen Kontaktbereich aufweisen. Oftmals ist es jedoch erforderlich, elektronische Bauelemente und Substrate über wenigstens einen unedlen Kontaktbereich miteinander zu verbinden. Mit den herkömmlichen Sinterverfahren lassen sich oftmals keine stabilen Verbindungen über diese unedlen Kontaktbereiche herstellen.

Lotpaste die eine Lotlegierung und eine Substanz die zwei Carbonsäure-Einheiter enthalten, sind bereits in GB 2 380 964 A1, DE 102005053553 A1, WO 2008/000349 und US 2003/0168123 A1 erwähnt.

Ferner wurde bereits vorgeschlagen, zum Verbinden von elektronischen Bauelementen und Substraten Pasten zu verwenden, die auf Nanopartikeln basieren, die eine Teilchengröße von maximal 100 nm besitzen. Der Umgang mit Nanopartikeln ist jedoch gesundheitlich bedenklich und wird daher aus Gründen der Arbeitsplatzsicherheit oftmals vermieden.

Eine Aufgabe der Erfindung war es daher, eine Paste zur Verfügung zu stellen, mit der es möglich ist, wenigstens ein elektronisches Bauelement mit wenigstens einem Substrat über Kontaktbereiche zu verbinden, wobei wenigstens einer dieser Kontaktbereiche ein unedles Metall enthält. Mit dieser Paste soll vorzugsweise ferner eine Verbindung zwischen dem elektronischen Bauelement und dem Substrat geschaffen werden, die eine hohe Zuverlässigkeit bei Temperaturen sicherstellt, denen das elektronische Bauelement beim Betrieb ausgesetzt ist. Außerdem sollen mit dieser Paste vorzugsweise andere aus dem Stand der Technik bekannte Nachteile überwunden werden.

Zudem war es eine Aufgabe der Erfindung, ein Verfahren zum Verbinden von wenigstens einem elektronischen Bauelement mit wenigstens einem Substrat über einen Kontaktbereich bereitzustellen, wobei wenigstens einer dieser Kontaktbereiche ein unedles Metall enthält.

Diese Aufgaben werden gelöst durch die Gegenstände der unabhängigen Ansprüche.

Die Erfindung stellt demnach eine Sinterpaste bereit, enthaltend (a) Metallpartikel, (b) wenigstens einen Aktivator, der wenigstens zwei Carbonsäure-Einheiten im Molekül trägt, und (c) ein Dispersionsmedium.

Weiterhin stellt die Erfindung ein Verfahren zum Verbinden wenigstens eines elektronischen Bauelements mit wenigstens einem Substrat über Kontaktbereiche bereit, wobei wenigstens einer dieser Kontaktbereiche ein unedles Metall enthält, umfassend die Schritte:
(i) Bereitstellen eines Substrats mit einem ersten Kontaktbereich und eines elektronischen Bauelements mit einem zweiten Kontaktbereich, wobei wenigstens einer dieser Kontaktbereiche ein unedles Metall enthält,
(ii) Bereitstellen einer Sinterpaste enthaltend
   (a) Metallpartikel,
   (b) wenigstens einen Aktivator, der wenigstens zwei Carbonsäure-Einheiten im Molekül trägt, und
   (c) ein Dispersionsmedium,
(iii) Erzeugen eines Aufbaus, wobei der erste Kontaktbereich des Substrats mit dem zweiten Kontaktbereich des elektronischen Bauelements über die Paste in Kontakt steht, und
(iv) Sintern des Aufbaus unter Herstellung eines Moduls, das wenigstens das Substrat und das elektronische Bauelement aufweist, die über die gesinterte Paste miteinander verbunden sind.

Die Erfindung beruht zum Teil auf der völlig überraschenden Erkenntnis, dass das bisher nicht mögliche Verbinden von elektronischen Bauelementen mit Substraten über wenigstens einen Kontaktbereich, der ein unedles Metall aufweist, durch Sintern mittels einer Paste ermöglicht wird, wenn diese Paste einen Aktivator enthält, der wenigstens zwei Carbonsäure-Einheiten im Molekül trägt.

Erfindungsgemäß wird eine Sinterpaste zur Verfügung gestellt.

Der Begriff Paste ist dabei nicht weiter eingeschränkt. Vorzugsweise wird unter Paste jedoch eine Dispersion verstanden, die mittels üblicher Auftragetechniken, wie zum Beispiel mittels Druckverfahren (zum Beispiel Siebdruck oder Schablonendruck), Dispenstechnik, Spraytechnik, Pintransfer oder Dippen, appliziert werden kann und eine hinreichende Viskosität und Kohäsion aufweist, die eine Verarbeitung der applizierten Paste in nachfolgenden Schritten ermöglicht.

Die erfindungsgemäße Sinterpaste enthält (a) Metallpartikel.

Unter Metallpartikel werden vorzugsweise Partikel verstanden, die ein Metall enthalten.

Gemäß der Ausführungsform ist das Metall aus der Gruppe ausgewählt, die aus Kupfer, Silber, Nickel und Aluminium besteht. Gemäß einer ganz bevorzugten Ausführungsform ist das Metall Silber.

Das Metall kann in den Metallpartikeln in reiner Form, zum Beispiel in einer Reinheit von wenigstens 99 Gewichtsprozent, in einer Reinheit von wenigstens 99,9 Gewichtsprozent, in einer Reinheit von wenigstens 99,99 Gewichtsprozent oder in einer Reinheit von wenigstens 99,999 Gewichtsprozent vorliegen. Andererseits können die Metallpartikel auch mehrere Metalle enthalten. Ebenso ist es möglich, dass die Metallpartikel Legierungen oder intermetallische Phasen aus mehreren Metallen enthalten.

Gemäß der Ausführungsform weisen die Metallpartikel als Hauptbestandteil ein Element auf, das aus der Gruppe ausgewählt ist, die aus Silber, Kupfer, Nickel und Aluminium besteht. Unter Hauptbestandteil wird erfindungsgemäß das Element verstanden, das in einem größeren Gewichtsanteil in dem betrachteten Metallpartikel vorkommt als alle anderen Elemente, die in diesem Metallpartikel enthalten sind.

Gemäß der Ausführungsform sind die Metallpartikel Silberpartikel, Kupferpartikel, Nickelpartikel oder Aluminiumpartikel. Unter Umständen können diese Metallpartikel an ihrer Oberfläche teilweise oder vollständig oxidiert sein.

Gemäß einer ganz besonders bevorzugten Ausführungsform sind die Metallpartikel Silberpartikel.

Die Form der Metallpartikel ist nicht weiter eingeschränkt. Vorzugsweise weisen die Metallpartikeln die Form von Flakes, eine ellipsoide Form oder eine runde Form auf. Ebenso ist es möglich, dass die Metallpartikel eine Mischung mehrerer Formen sind.

Gemäß einer besonders bevorzugten Ausführungsform weisen die Metallpartikel die Form von Flakes auf. Der Anteil an Flakes liegt bei dieser Ausführungsform vorzugsweise bei wenigstens 70 Gewichtsprozent, mehr bevorzugt bei wenigstens 80 Gewichtsprozent, noch mehr bevorzugt bei wenigstens 90 Gewichtsprozent und besonders bevorzugt bei wenigstens 99 Gewichtsprozent, bezogen auf das Gesamtgewicht der Metallpartikel.

Gemäß einer weiteren bevorzugten Ausführungsform weisen die Metallpartikel ein Längenverhältnis von mehr als 1,0, mehr bevorzugt ein Längenverhältnis von mehr als 1,2, noch mehr bevorzugt ein Längenverhältnis von mehr als 1,5 und besonders bevorzugt ein Längenverhältnis von mehr als 2,0 auf. Die Metallpartikel weisen vorzugsweise ein Längenverhältnis von nicht mehr als 20, mehr bevorzugt ein Längenverhältnis von nicht mehr als 15 und noch mehr bevorzugt ein Längenverhältnis von nicht mehr als 10 auf. Unter Längenverhältnis wird dabei das Verhältnis von der Strecke (a), die durch die breiteste Stelle des Querschnitts eines Metallpartikels verläuft, zu der Strecke (b), die durch die breiteste Stelle dieses Querschnitts entlang einer Senkrechten zu Strecke (a) verläuft, verstanden. Der Querschnitt ist in diesem Fall die Schnittfläche durch einen Metallpartikel mit dem größten Flächeninhalt. Weist ein Metallpartikel beispielsweise einen rechteckigen Querschnitt auf, so ist das Längenverhältnis das Verhältnis von Länge zu Breite des Querschnitts. Beispielsweise hat ein Metallpartikel mit einem rechteckigen Querschnitt, der eine Länge von 2 µm und eine Breite von 1 µm besitzt, ein Längenverhältnis von 2.

Gemäß noch einer weiteren bevorzugten Ausführungsform liegt der Anteil an Metallpartikeln mit einem Längenverhältnis von mehr als 1,0, mehr bevorzugt der Anteil an Metallpartikeln mit einem Längenverhältnis von mehr als 1,2 und noch mehr bevorzugt der Anteil an Metallpartikeln mit einem Längenverhältnis von mehr als 1,5 bei wenigstens 70 Gewichtsprozent, mehr bevorzugt bei wenigstens 80 Gewichtsprozent und noch mehr bevorzugt bei wenigstens 90 Gewichtsprozent, bezogen auf das Gesamtgewicht der Metallpartikel.

Die in der Paste enthaltenen Metallpartikel können unterschiedliche Partikelgrößenverteilungen aufweisen.

Gemäß einer bevorzugten Ausführungsform liegt die mittlere Partikelgröße (der d50-Wert) der Metallpartikel bei wenigstens 500 nm, mehr bevorzugt bei wenigstens 650 nm und noch mehr bevorzugt bei wenigstens 1 µm. Die mittlere Partikelgröße (der d50-Wert) liegt vorzugsweise bei nicht mehr als 20 µm, mehr bevorzugt bei nicht mehr als 15 µm und noch mehr bevorzugt bei nicht mehr als 10 µm. Demnach liegt die mittlere Partikelgröße (der d50-Wert) vorzugsweise im Bereich von 500 nm - 20 µm, mehr bevorzugt im Bereich von 650 nm - 15 µm und noch mehr bevorzugt im Bereich von 1-10 µm. Unter mittlerer Partikelgröße (d50-Wert) wird vorzugsweise eine Partikelgröße verstanden, die von 50 Volumenprozent der Metallpartikel unterschritten und von 50 Volumenprozent der Metallpartikel überschritten wird.

Gemäß einer weiteren bevorzugten Ausführungsform liegt die Partikelgröße d10 (der d10-Wert) der Metallpartikel bei wenigstens 150 nm, mehr bevorzugt bei wenigstens 200 nm und noch mehr bevorzugt bei wenigstens 250 nm. Die Partikelgröße d10 (der d10-Wert) liegt vorzugsweise bei nicht mehr als 5 µm, mehr bevorzugt bei nicht mehr als 4 µm und noch mehr bevorzugt bei nicht mehr als 3 µm. Demnach liegt die Partikelgröße d10 (der d10-Wert) vorzugsweise im Bereich von 150 nm - 5 µm, mehr bevorzugt im Bereich von 200 nm - 4 µm und noch mehr bevorzugt im Bereich von 250 nm - 3 µm. Unter Partikelgröße d10 (d10-Wert) wird vorzugsweise eine Partikelgröße verstanden, die von 10 Volumenprozent der Metallpartikel unterschritten und von 90 Volumenprozent der Metallpartikel überschritten wird.

Gemäß einer weiteren bevorzugten Ausführungsform liegt die Partikelgröße d90 (der d90-Wert) der Metallpartikel bei wenigstens 1,75 µm, mehr bevorzugt bei wenigstens 2 µm und noch mehr bevorzugt bei wenigstens 2,25 µm. Die Partikelgröße d90 (der d90-Wert) liegt vorzugsweise bei nicht mehr als 100 µm, mehr bevorzugt bei nicht mehr als 50 µm und noch mehr bevorzugt bei nicht mehr als 25 µm. Demnach liegt die Partikelgröße d90 (der d90-Wert) vorzugsweise im Bereich von 1,75 - 100 µm, mehr bevorzugt im Bereich von 2 - 50 µm und noch mehr bevorzugt im Bereich von 2,25 - 25 µm. Unter Partikelgröße d90 (d90-Wert) wird vorzugsweise eine Partikelgröße verstanden, die von 90 Volumenprozent der Metallpartikel unterschritten und von 10 Volumenprozent der Metallpartikel überschritten wird.

Die vorstehenden Angaben zur Partikelgröße beziehen sich vorzugsweise auf Analysen zur Bestimmung der Partikelgröße durch die LALLS (*Low Angle Laser Light Scattering*)-Methode gemäß der ISO 13320 (2009). Als Messinstrument dient dabei vorzugsweise der *Mastersizer 2000* (Malvern Instruments Ltd., Worcestershire, Großbritannien). Die Messung und die Auswertung erfolgen dabei unter geeigneten Bedingungen (Zum Beispiel: Standard: Silber mit Brechungsindex von 0,14, Absorption von 3,99; Dispersionsmedium: Ethanol mit einem Brechungsindex von 1,36; Verfahren: 0,5 Gramm Pulver werden mit 200 ml Ethanol versetzt, die erhaltene Suspension wird für 5 Minuten sonifiziert und ein Teil der Suspension wird zur Vermessung in das *Hydro Accessory* zum *Mastersizer 2000* überführt; Optisches Modell für die Auswertung: Mie-Theorie).

Vorzugsweise weisen die Metallpartikel eine spezifische Oberfläche gemäß BET (*Brunauer, Emett,* Teller)-Messung im Bereich von 1 - 5 m²/g und mehr bevorzugt im Bereich von 1 - 4 m²/g auf. Die BET-Messung erfolgt dabei vorzugsweise nach der DIN ISO 9277:2003-05.

Die Metallpartikel können gegebenenfalls auch als Mischung mehrerer Fraktionen von Metallpartikeln vorliegen. Die Fraktionen können sich beispielsweise nach Zusammensetzung, Form oder Größe der Metallpartikel unterscheiden.

Der Anteil an Metallpartikeln liegt vorzugsweise bei wenigstens 50 Gewichtsprozent, mehr bevorzugt bei wenigstens 60 Gewichtsprozent, noch mehr bevorzugt bei wenigstens 70 Gewichtsprozent und besonders bevorzugt bei wenigstens 80 Gewichtsprozent, bezogen auf das Gesamtgewicht der Paste. Vorzugsweise beträgt der Anteil an Metallpartikeln nicht mehr als 95 Gewichtsprozent, mehr bevorzugt nicht mehr als 93 Gewichtsprozent und noch mehr bevorzugt nicht mehr als 90 Gewichtsprozent, bezogen auf das Gesamtgewicht der Paste. Dementsprechend liegt der Anteil an Metallpartikeln im Bereich von 50 - 95 Gewichtsprozent, mehr bevorzugt im Bereich von 60 - 93 Gewichtsprozent und noch mehr bevorzugt im Bereich von 70 - 90 Gewichtsprozent, bezogen auf das Gesamtgewicht der Paste.

Die Metallpartikel können ein Coating aufweisen.

Unter einem Coating von Metallpartikeln wird erfindungsgemäß eine festhaftende Schicht auf der Oberfläche der Metallpartikel verstanden. Festhaftende Schicht bedeutet vorzugsweise, dass sich die Schicht nicht bereits gravitationsbedingt von den Metallpartikeln löst.

Das Coating der Metallpartikel enthält üblicherweise wenigstens eine Coatingverbindung.

Bei dieser wenigstens einen Coatingverbindung handelt es sich vorzugsweise um eine organische Verbindung.

Die Coatingverbindung ist vorzugsweise aus der Gruppe ausgewählt, die aus gesättigten Verbindungen, einfach ungesättigten Verbindungen, mehrfach ungesättigten Verbindungen und Mischungen davon besteht.

Vorzugsweise ist die Coatingverbindung aus der Gruppe ausgewählt, die aus verzweigten Verbindungen, unverzweigten Verbindungen und Mischungen davon besteht.

Die Coatingverbindung weist vorzugsweise 8 - 28, noch mehr bevorzugt 12 - 24 und besonders bevorzugt 12 - 18 Kohlenstoffatome auf.

Gemäß einer bevorzugten Ausführungsform ist die Coatingverbindung aus der Gruppe ausgewählt, die aus Fettsäuren, Fettsäuresalzen und Fettsäureestern besteht.

Als Fettsäuresalze kommen vorzugsweise Salze in Betracht, deren anionische Komponente die deprotonierte Fettsäure darstellt, und deren kationische Komponente aus der Gruppe ausgewählt ist, die aus Ammoniumionen, Monoalkylammoniumionen, Dialkylammoniumionen, Trialkylammoniumionen, Lithiumionen, Natriumionen, Kaliumionen, Kupferionen und Aluminiumionen besteht.

Bevorzugte Fettsäureester leiten sich von den entsprechenden Fettsäuren ab, wobei die Hydroxylgruppen der Carbonsäureeinheiten durch Alkylgruppen, insbesondere Methylgruppen, Ethylgruppen, Propylgruppen oder Butylgruppen, ersetzt sind.

Gemäß einer bevorzugten Ausführungsform ist die wenigstens eine Coatingverbindung aus der Gruppe ausgewählt, die aus Caprylsäure (Octansäure), Caprinsäure (Decansäure), Laurinsäure (Dodecansäure), Myristinsäure (Tetradecansäure), Palmitinsäure (Hexadecansäure), Stearinsäure (Octadecansäure), Mischungen davon, sowie den entsprechenden Estern und Salzen, sowie Mischungen davon, besteht.

Gemäß einer besonders bevorzugten Ausführungsform ist die wenigstens eine Coatingverbindung aus der Gruppe ausgewählt, die aus Laurinsäure (Dodecansäure), Stearinsäure (Octadecansäure), Natriumstearat, Kaliumstearat, Aluminiumstearat, Kupferstearat, Natriumpalmitat und Kaliumpalmitat besteht.

Die vorzugsweise verwendeten gecoateten Metallpartikel können kommerziell erhältlich sein. Die entsprechenden Coatingverbindungen können auf fachübliche Weise auf die Oberfläche der Metallpartikel aufgetragen werden.

Beispielsweise ist es möglich, die Coatingverbindungen, insbesondere die vorstehend erwähnten Stearate oder Palmitate, in Lösungsmitteln aufzuschlämmen und die aufgeschlämmten Coatingverbindungen in Kugelmühlen mit den Metallpartikeln zu vermahlen. Nach dem Mahlen werden die dann mit den Coatingverbindungen beschichteten Metallpartikel getrocknet und anschließend entstaubt.

Vorzugsweise beträgt der Anteil der wenigstens einen Coatingverbindung, die aus der Gruppe ausgewählt ist, die aus Fettsäuren, Fettsäuresalzen und Fettsäureestern besteht, bezogen auf das Gesamtgewicht des Coatings, wenigstens 80 Gewichtsprozent, mehr bevorzugt wenigstens 90 Gewichtsprozent, besonders bevorzugt wenigstens 95 Gewichtsprozent, ganz besonders bevorzugt wenigstens 99 Gewichtsprozent und insbesondere 100 Gewichtsprozent.

Gemäß einer bevorzugten Ausführungsform beträgt der Gesamtanteil der Coatingverbindungen 0,05 - 3 Gewichtsprozent, mehr bevorzugt 0,07 - 2,5 Gewichtsprozent und noch mehr bevorzugt 0,1 - 2,2 Gewichtsprozent, bezogen auf das Gesamtgewicht der gecoateten Metallpartikel.

Der Coatinggrad, der als Verhältnis der Masse an Coatingverbindungen zur Oberfläche der Metallpartikel definiert ist, beträgt vorzugsweise 0,00005 - 0,03 g, mehr bevorzugt 0,0001 - 0,02 g und noch mehr bevorzugt 0,0005 - 0,02 g an Coatingverbindungen pro Quadratmeter (m²) Oberfläche der Metallpartikel.

Überraschenderweise wurde gefunden, dass ein Coating auf den Metallpartikeln der Paste die Zuverlässigkeit der Verbindung zwischen elektronischem Bauelement und Substrat im Hinblick auf die Festigkeit auf erhebliche Weise begünstigt.

Erfindungsgemäß enthält die Paste wenigstens einen Aktivator (b).

Der Aktivator trägt wenigstens zwei Carbonsäure-Einheiten im Molekül. Demnach kann der Aktivator auch mehr als zwei, mehr als drei oder mehr als vier Carbonsäureeinheiten im Molekül tragen.

Die Lage der Carbonsäureeinheiten im Molekül ist nicht weiter eingeschränkt. Vorzugsweise sind die Carbonsäureeinheiten des Aktivators jedoch endständig angeordnet.

Als vorteilhaft hat sich ferner erwiesen, dass die Carbonsäureeinheiten des Aktivators über nicht mehr als fünf Kohlenstoffatome, mehr bevorzugt über nicht mehr als vier Kohlenstoffatome, noch mehr bevorzugt über nicht mehr als drei Kohlenstoffatome, besonders bevorzugt über nicht mehr als zwei Kohlenstoffatome und ganz besonders bevorzugt über nicht mehr als ein Kohlenstoffatom miteinander verbunden sind. Vorzugsweise sind zudem die Carbonsäureeinheiten des Aktivators über wenigstens ein Kohlenstoffatom miteinander verbunden. Bei der Ermittlung der Anzahl an Kohlenstoffatomen, über die die Carbonsäureeinheiten des Aktivators miteinander verbunden sind, sind im Rahmen der Erfindung die Kohlenstoffatome der Carbonsäureeinheit selbst nicht mitzurechnen. Demnach sind zum Beispiel im Fall der Malonsäure (HOOCCH₂COOH) die Carbonsäureeinheiten über ein Kohlenstoffatom miteinander verbunden, während im Fall der Maleinsäure (HOOC(CH)₂COOH) die Carbonsäureeinheiten über zwei Kohlenstoffatome miteinander verbunden sind.

Gemäß einer bevorzugten Ausführungsform weist der Aktivator wenigstens 2 Kohlenstoffatome und mehr bevorzugt wenigstens 3 Kohlenstoffatome auf. Der Aktivator weist vorzugsweise nicht mehr als 18 Kohlenstoffatome, mehr bevorzugt nicht mehr als 14 Kohlenstoffatome, noch mehr bevorzugt nicht mehr als 12 Kohlenstoffatome, besonders bevorzugt nicht mehr als 10 Kohlenstoffatome, ganz besonders bevorzugt nicht mehr als 8 Kohlenstoffatome und insbesondere nicht mehr als 6 Kohlenstoffatome auf. Demnach weist der Aktivator vorzugsweise 2 - 18 Kohlenstoffatome, mehr bevorzugt 2 - 14 Kohlenstoffatome, noch mehr bevorzugt 2 - 12 Kohlenstoffatome, besonders bevorzugt 2 - 10 Kohlenstoffatome, ganz besonders bevorzugt 2 - 8 Kohlenstoffatome, insbesondere 2 - 6 Kohlenstoffatome oder 3 - 6 Kohlenstoffatome auf.

Beim Aktivator kann es sich um eine gesättigte oder ungesättigte Verbindung handeln.

Ein ungesättigter Aktivator weist vorzugsweise wenigstens eine Kohlenstoff-Kohlenstoff-Doppelbindung im Molekül auf. Als besonders vorteilhafte Aktivatoren haben sich ferner cis-Isomere erwiesen.

Der Aktivator kann eine verzweigte oder unverzweigte Verbindung sein.

Bei einem verzweigten Aktivator sind Länge, Art und Lage der Seitenketten nicht weiter eingeschränkt. Vorzugsweise weist ein verzweigter Aktivator wenigstens eine Seitenkette mit einer Länge von 1 - 8 Kohlenstoffatomen auf. Üblicherweise handelt es sich bei dieser Seitenkette um eine Alkylkette, die gegebenenfalls auch substituiert sein kann.

Der Aktivator kann eine aromatische oder aliphatische Verbindungen sein. Vorzugsweise ist der Aktivator jedoch eine aliphatische Verbindung.

Neben den in den Carbonsäureeinheiten enthaltenen Sauerstoffatomen kann der erfindungsgemäße Aktivator weitere Heteroatome tragen. Vorzugsweise enthält der Aktivator jedoch neben den Sauerstoffatomen der Carbonsäureeinheiten keine Heteroatome.

Die Carbonsäureeinheiten des Aktivators liegen vorzugsweise in nicht deprotonierter Form in der Paste vor. Es kann daher vorteilhaft sein, das Dispersionsmedium so zu wählen, dass keine Dissoziation der Carbonsäureeinheiten erfolgt.

Als vorteilhaft hat sich in vielen Fällen herausgestellt, dass der Aktivator einen Zersetzungspunkt unterhalb einer Temperatur von 300°C, mehr bevorzugt unterhalb einer Temperatur von 270°C, noch mehr bevorzugt unterhalb einer Temperatur von 240°C und besonders bevorzugt unterhalb einer Temperatur von 200°C aufweist. In diesen Fällen liegt der Zersetzungspunkt des Aktivators vorzugsweise im Bereich von 100 - 300°C, mehr bevorzugt im Bereich von 110°C - 270°C, noch mehr bevorzugt im Bereich von 120°C - 240°C und besonders bevorzugt im Bereich von 130°C - 200°C.

In vielen Fällen hat es sich zudem als vorteilhaft erwiesen, dass der Schmelzpunkt des Aktivators bei wenigstens 80°C, mehr bevorzugt bei wenigstens 90°C und noch mehr bevorzugt bei wenigstens 100°C liegt. Vorzugsweise liegt der Schmelzpunkt in diesen Fällen bei nicht mehr als 200°C, mehr bevorzugt bei nicht mehr als 180°C und noch mehr bevorzugt bei nicht mehr als 160°C. Demnach liegt der Schmelzpunkt des Aktivators vorzugsweise im Bereich von 80°C - 200°C, mehr bevorzugt im Bereich von 90 - 180°C und noch mehr bevorzugt im Bereich von 100°C -160°C.

Der Aktivator kann in nicht komplexierter Form vorliegen. Andererseits kann der Aktivator auch in komlexierter Form, vorzugsweise als Komplex mit einem Nebengruppenelement des Periodensystems der Elemente, vorliegen. Liegt der Aktivator in komplexierter Form vor, so kann es sich hierbei insbesondere um eine komplexierte Dicarbonsäure handeln.

Gemäß einer bevorzugten Ausführungsform ist der Aktivator aus der Gruppe ausgewählt, die aus Oxalsäure, Malonsäure, Bernsteinsäure, Glutarsäure, Adipinsäure, Pimelinsäure, cis-Butendisäure (Maleinsäure), trans-Butendisäure (Fumarsäure), cis-2-Pentensäure, trans-2-Pentensäure und Dimethylmalonsäure besteht.

Gemäß einer besonders bevorzugten Ausführungsform ist der Aktivator aus der Gruppe ausgewählt, die aus Oxalsäure, Malonsäure, Maleinsäure und Dimethylmalonsäure besteht.

Gemäß einer ganz besonders bevorzugten Ausführungsform ist der Aktivator aus der Gruppe ausgewählt, die aus Oxalsäure, Malonsäure, Maleinsäure und Dimethylmalonsäure besteht.

Der Anteil des Aktivators beträgt vorzugsweise wenigstens 0,1 Gewichtsprozent, mehr bevorzugt wenigstens 0,3 Gewichtsprozent, noch mehr bevorzugt wenigstens 0,5 Gewichtsprozent, besonders bevorzugt wenigstens 1 Gewichtsprozent und ganz besonders bevorzugt wenigstens 2 Gewichtsprozent, bezogen auf das Gesamtgewicht der Paste. Vorzugsweise beträgt der Anteil des Aktivators nicht mehr als 30 Gewichtsprozent, mehr bevorzugt nicht mehr als 20 Gewichtsprozent, noch mehr bevorzugt nicht mehr als 10 Gewichtsprozent, besonders bevorzugt nicht mehr als 7 Gewichtsprozent und ganz besonders bevorzugt nicht mehr als 5 Gewichtsprozent, bezogen auf das Gesamtgewicht der Paste. Dementsprechend liegt der Anteil des Aktivators vorzugsweise im Bereich von 0,1 - 30 Gewichtsprozent, mehr bevorzugt im Bereich von 0,3 - 20 Gewichtsprozent, noch mehr bevorzugt im Bereich von 0,5 - 10 Gewichtsprozent, besonders bevorzugt im Bereich von 1 - 7 Gewichtsprozent und ganz besonders bevorzugt im Bereich von 2 - 5 Gewichtsprozent, bezogen auf das Gesamtgewicht der Paste.

Die erfindungsgemäße Paste enthält ferner ein Dispersionsmedium (c).

In dem Dispersionsmedium (c) sind vorzugsweise die Metallpartikel (a) dispergierbar. Der wenigstens eine Aktivator (b) kann in dem Dispersionsmedium (c) ebenfalls dispergierbar sein. Möglich ist aber auch, dass der Aktivator (b) in dem Dispersionsmedium (c) löslich ist.

Bei dem Dispersionsmedium kann es sich um ein fachübliches Dispersionsmedium handeln.

Dementsprechend kann das Dispersionsmedium ein oder mehrere Lösungsmittel enthalten.

Dabei kommen als Lösungsmittel beispielsweise organische Verbindungen in Betracht.

Diese organischen Verbindungen enthalten vorzugsweise 5 - 50 Kohlenstoffatome, mehr bevorzugt 8 - 32 Kohlenstoffatome und noch mehr bevorzugt 18 - 32 Kohlenstoffatome.

Die organischen Verbindungen können verzweigt oder unverzweigt sein. Bei den organischen Verbindungen kann es sich auch um zyklische Verbindungen handeln.

Die organischen Verbindungen können zudem aliphatischer oder aromatischer Natur sein.

Ferner können die als Lösungsmittel verwendeten organischen Verbindungen gesättigte oder einfach oder mehrfach ungesättigte Verbindungen sein.

Die organischen Verbindungen können ferner auch Heteroatome, insbesondere Sauerstoffatome oder Stickstoffatome, aufweisen. Diese Heteroatome können Teil von funktionellen Gruppen sein. Als funktionelle Gruppen kommen beispielsweise Carbonsäuregruppen, Estergruppen, Ketogruppen, Aldehydgruppen, Hydroxylgruppen, Aminogruppen, Amidgruppen, Azogruppen, Imidgruppen, Cyanogruppen oder Nitrilgruppen in Betracht.

Demnach können als Lösungsmittel zum Beispiel α-Terpineol ((R)-(+)-α-Terpineol, (S)-(-)-α-Terpineol oder Racemate), β-Terpineol, γ-Terpineol, δ-Terpineol, Mischungen der vorstehend genannten Terpineole, N-Methyl-2-pyrrolidon, Ethylenglycol, Dimethylacetamid, Alkohole, insbesondere solche, die eine unverzweigte oder verzweigte Kette mit 5 - 9 Kohlenstoffatomen aufweisen, 1-Hexanol, 1-Octanol, 1-Dodecanol, 1-Tridecanol, 2-Tridecanol, 3-Tridecanol, 4-Tridecanol, 5-Tridecanol, 6-Tridecanol, Isotridecanol, dibasische Ester (vorzugsweise Dimethylester der Glutar-, Adipin- oder Bernsteinsäure oder Mischungen davon), Glycerin, Diethylenglycol, Triethylenglycol oder Mischungen hiervon zum Einsatz kommen.

Gemäß einer weiteren bevorzugten Ausführungsform enthält das Dispersionsmedium wenigstens ein aprotisches Lösungsmittel. Es kann auch vorteilhaft sein, dass der Anteil des wenigstens einen aprotischen Lösungsmittels wenigstens 70 Gewichtsprozent, mehr bevorzugt wenigstens 80 Gewichtsprozent, noch mehr bevorzugt wenigstens 90 Gewichtsprozent, besonders bevorzugt wenigstens 95 Gewichtsprozent und ganz besonders bevorzugt wenigstens 99 Gewichtsprozent, bezogen auf das Gesamtgewicht aller bei einer Temperatur von 25°C und einem Druck von 1,1013 bar flüssigen Bestandteile der Paste, beträgt.

Das aprotische Lösungsmittel ist vorzugsweise aus der Gruppe ausgewählt, die aus aliphatischen Kohlenwasserstoffverbindungen, Carbonsäureestern und Ethern besteht.

Gemäß einer besonders bevorzugten Ausführungsform enthält das Dispersionsmedium wenigstens eine aliphatische Kohlenwasserstoffverbindung. Diese aliphatische Kohlenwasserstoffverbindung weist vorzugsweise 5 - 50 Kohlenstoffatome, mehr bevorzugt 8 - 32 Kohlenstoffatome und noch mehr bevorzugt 18 - 32 Kohlenstoffatome auf.

Bei der aliphatischen Kohlenwasserstoffverbindung kann es sich demnach beispielsweise auch um ein Paraffin handeln.

Der Anteil des Dispersionsmedium beträgt vorzugsweise wenigstens 5 Gewichtsprozent, mehr bevorzugt wenigstens 8 Gewichtsprozent und noch mehr bevorzugt wenigstens 10 Gewichtsprozent, bezogen auf das Gesamtgewicht der Paste. Vorzugsweise beträgt der Anteil des Dispersionsmediums nicht mehr als 40 Gewichtsprozent, mehr bevorzugt nicht mehr als 30 Gewichtsprozent, noch mehr bevorzugt nicht mehr als 20 Gewichtsprozent und besonders bevorzugt nicht mehr als 15 Gewichtsprozent, bezogen auf das Gesamtgewicht der Paste. Dementsprechend liegt der Anteil des Dispersionsmediums vorzugsweise im Bereich von 5 - 40 Gewichtsprozent, mehr bevorzugt im Bereich von 8 - 30 Gewichtsprozent und noch mehr bevorzugt im Bereich von 10 - 20 Gewichtsprozent, bezogen auf das Gesamtgewicht der Paste.

Die erfindungsgemäße Paste kann neben den Metallpartikeln (a), dem wenigstens einen Aktivator (b) und dem Dispersionsmedium (c) gegebenenfalls weitere Stoffe enthalten.

Als weitere Stoffe kommen beispielsweise fachübliche Verdünner, Verdicker und Stabilisatoren in Betracht.

Vorzugsweise liegt der Anteil anderer Stoffe als (a) den Metallpartikeln, (b) dem wenigstens einen Aktivator, der wenigstens zwei Carbonsäure-Einheiten im Molekül trägt, und (c) dem Dispersionsmedium bei nicht mehr als 20 Gewichtsprozent, mehr bevorzugt bei nicht mehr als 15 Gewichtsprozent, noch mehr bevorzugt bei nicht mehr als 10 Gewichtsprozent, besonders bevorzugt bei nicht mehr als 5 Gewichtsprozent, ganz besonders bevorzugt bei nicht mehr als 3 Gewichtsprozent und insbesondere bei nicht mehr als 1 Gewichtsprozent, bezogen auf das Gesamtgewicht der Paste.

Die erfindungsgemäße Paste kann auf fachübliche Weise hergestellt werden.

Beispielsweise kann die Paste durch Vermischen der Metallpartikel (a), des wenigstens einen Aktivators (b), der wenigstens zwei Carbonsäure-Einheiten im Molekül trägt, und des Dispersionsmediums (c) hergestellt werden.

Gemäß einer besonders bevorzugten Ausführungsform wird die Paste in mehreren Schritten hergestellt.

In einem ersten Schritt wird dabei der wenigstens eine Aktivator (b) gemahlen. Das Mahlen kann in einer Mühle erfolgen und dazu dienen, die Dispergierbarkeit des Aktivators in dem Dispersionsmedium (c) zu verbessern.

In einem zweiten Schritt kann dann der gemahlene Aktivator (b) mit dem Dispersionsmedium (c) vereinigt werden. Üblicherweise wird in diesem Schritt eine homogene Suspension des Aktivators (b) in dem Dispersionsmedium (c) hergestellt. Zur Bildung dieser homogenen Suspension kann die Mischung gegebenenfalls mit einem Mischer, zum Beispiel einem Ultraturaxmischer, behandelt werden.

In einem dritten Schritt kann schließlich die Suspension aus dem zweiten Schritt mit den Metallpartikeln (a) vereinigt werden. Gegebenenfalls wird die erhaltene Mischung danach, zum Beispiel manuell mit einem Spatel, homogenisiert. Im Anschluss kann die Mischung, falls erforderlich, mehrmals über einen Walzenstuhl gegeben und weiter homogenisiert werden. Danach kann die erhaltene Paste für die beabsichtigte Verwendung eingesetzt werden.

Die erfindungsgemäße Paste wird vorzugsweise zum Verbinden wenigstens eines elektronischen Bauelements mit wenigstens einem Substrat verwendet.

Dabei wird das wenigstens eine elektronische Bauelement auf dem Substrat vorzugsweise befestigt.

Diese Befestigung erfolgt durch Sintern. Unter Sintern wird erfindungsgemäß das Verbinden von zwei oder mehr Bauelementen durch Erhitzen unter Umgehung der flüssigen Phase verstanden. Demnach wird durch das Sintern vorzugsweise eine stoffschlüssige Verbindung zwischen dem wenigstens einen elektronischen Bauelement und dem Substrat hergestellt.

Unter elektronischem Bauelement wird in fachüblicher Weise ein Gegenstand verstanden, der Teil einer elektronischen Anordnung sein kann. Gemäß einer bevorzugten Ausführungsform wird darunter ein nicht weiter zerlegbares Einzelteil verstanden, das als Bestandteil einer elektronischen Schaltung dienen kann. Das elektronische Bauelement kann als Einheit gegebenenfalls aus mehreren Bauteilen bestehen. Bei dem elektronischen Bauelement kann es sich beispielsweise um ein aktives Bauelement oder ein passives Bauelement handeln. Gemäß besonderen Ausführungsformen wird das elektronische Bauelement in der Hochleistungselektronik verwendet. Vorzugsweise ist das elektronische Bauelement aus der Gruppe ausgewählt, die aus Dioden (zum Beispiel LEDs, *Light Emitting Diodes,* lichtemittierende Dioden), Transistoren (zum Beispiel IGBTs, *Insulated-Gate Bipolar Transistors,* Bipolartransistoren mit isolierter Gate-Elektrode), integrierten Schaltungen, Halbleiterchips, Nacktchips (*Dies*), Widerständen, Sensoren, Kondensatoren, Spulen und Kühlkörpern besteht.

Unter Substrat wird in allgemeiner Form ein Gegenstand verstanden, der mit einem elektronischen Bauelement verbindbar ist. Gemäß einer bevorzugten Ausführungsform ist das Substrat aus der Gruppe ausgewählt, die aus *Leadframes,* DCB-Substraten (*Direct-Copper-Bonded-*Substraten) und keramischen Substraten besteht.

Gemäß einer bevorzugten Ausführungsform werden folgende Paare aus elektronischem Bauelement und Substrat miteinander verbunden: LED/*Leadframe,* LED/keramisches Substrat, *Die*/*Leadframe, Die*/keramisches Substrat, *Die*/DCB-Substrat, Diode/*Leadframe*, Diode/keramisches Substrat, Diode/DCB-Substrat, IGBT/*Leadframe*, IGBT/keramisches Substrat, IGBT/DCB-Substrat, integrierte Schaltung/*Leadframe*, integrierte Schaltung/keramisches Substrat, integrierte Schaltung/DCB-Substrat, *Sensor*/*Leadframe,* Sensor/keramisches Substrat, Kühlkörper (vorzugsweise Kupfer- oder Aluminiumkühlkörper)/DCB, Kühlkörper (vorzugsweise Kupfer- oder Aluminiumkühlkörper)/keramisches Substrat, Kühlkörper/*Leadframe*, Kondensator (vorzugsweise Tantalkondensator, mehr bevorzugt in ungehäustem Zustand)/Leadframe.

Gemäß einer weiteren bevorzugten Ausführungsform können mit dem Substrat mehrere elektronische Bauelemente verbunden werden. Es kann ferner bevorzugt sein, dass elektronische Bauelemente auf gegenüberliegenden Seiten des Substrats angeordnet werden.

Elektronisches Bauelement und Substrat weisen jeweils wenigstens einen Kontaktbereich auf.

Unter Kontaktbereich wird dabei erfindungsgemäß ein Bereich des elektronischen Bauelements, mit dem die Kontaktierung des Substrats über die erfindungsgemäße Paste erfolgt, oder ein Bereich des Substrats, mit dem die Kontaktierung des elektronischen Bauelements über die erfindungsgemäße Paste erfolgt, verstanden. Dementsprechend weist der Kontaktbereich des elektronischen Bauelements vorzugsweise eine Kontaktfläche auf, die nach dem Verbinden mit dem Substrat von diesem bedeckt ist. Ebenso weist der Kontaktbereich des Substrats vorzugsweise eine Kontaktfläche auf, die nach dem Verbinden mit dem elektronischen Bauelement von diesem bedeckt ist. Vorzugsweise weist der Kontaktbereich des elektronischen Bauelements ein Volumen auf, das durch die Kontaktfläche des Kontaktbereichs des elektronischen Bauelements (definiert durch Breite und Länge der Kontaktfläche) und eine Dicke von 50 nm definiert ist. Ebenso weist der Kontaktbereich des Substrats vorzugsweise ein Volumen auf, das durch die Kontaktfläche des Kontaktbereichs des Substrats (definiert durch Breite und Länge der Kontaktfläche) und eine Dicke von 50 nm definiert ist. Dieses Volumen des Kontaktbereichs von elektronischen Bauelement und Substrat weist ein bestimmtes Gewicht auf. Dieses Gewicht kann beispielsweise dadurch bestimmt werden, dass mittels Auger-Spektroskopie der Kontaktbereich durch *Sputtering* abgetragen und danach das Gewicht des abgetragenen Bereichs ermittelt wird.

Der Kontaktbereich kann ein Bereich sein, der auf das elektronische Bauelement oder das Substrat aufgebracht ist. Beispielsweise wird in vielen Fällen auf eine zu verbindende Oberfläche eines elektronischen Bauelements eine Metallisierung aufgebracht. Diese Metallisierung kann in vielen Fällen eine Dicke im Bereich von 100 - 400 nm einnehmen. Eine solche Metallisierung oder ein Bereich davon kann einen erfindungsgemäßen Kontaktbereich darstellen.

Andererseits kann der Kontaktbereich auch integraler Bestandteil des elektronischen Bauelements oder des Substrats sein. Zum Beispiel kann erfindungsgemäß als Substrat ein *Leadfra*me aus Kupfer verwendet werden. Solche Leadframes können eine Dicke im Bereich von mehreren Millimetern aufweisen. In einem solchen Fall kann ein Bereich dieses *Leadframes,* der sich nicht notwendigerweise stofflich oder strukturell von anderen Bereichen dieses *Leadframes* unterscheiden muss, einen erfindungsgemäßen Kontaktbereich darstellen.

Wenigstens einer der Kontaktbereiche von elektronischem Bauelement und Substrat enthält wenigstens ein unedles Metall.

Gemäß einer bevorzugten Ausführungsform enthält wenigstens einer der Kontaktbereiche von elektronischem Bauelement und Substrat, der ein unedles Metall aufweist, wenigstens ein Element, das aus der Gruppe ausgewählt ist, die aus (i) Kupfer, Aluminium, Zink und Nickel, (ii) Legierungen, die wenigstens ein Element ausgewählt aus Kupfer, Aluminium, Zink und Nickel aufweisen, und (iii) intermetallischen Phasen, die wenigstens ein Element ausgewählt aus Kupfer, Aluminium, Zink und Nickel aufweisen, besteht.

Der Anteil des wenigstens einen unedlen Metalls, beispielsweise eines unedlen Metalls, das aus der Gruppe ausgewählt ist, die aus Kupfer, Aluminium, Zink und Nickel besteht, liegt vorzugsweise bei wenigstens 5 Gewichtsprozent, mehr bevorzugt bei wenigstens 7 Gewichtsprozent, noch mehr bevorzugt bei wenigstens 10 Gewichtsprozent, besonders bevorzugt bei wenigstens 15 Gewichtsprozent, ganz besonders bevorzugt bei wenigstens 50 Gewichtsprozent und insbesondere bei wenigstens 90 Gewichtsprozent, bezogen auf das Gewicht des Kontaktbereichs, der ein unedles Metall aufweist.

Vorzugsweise bildet ein unedles Metall, mehr bevorzugt ein unedles Metall, das aus der Gruppe ausgewählt ist, die aus Kupfer, Aluminium, Zink und Nickel besteht, den Hauptbestandteil des Kontaktbereichs. Unter Hauptbestandteil des Kontaktbereichs wird erfindungsgemäß das Element verstanden, das in einem größeren Gewichtsanteil in dem Kontaktbereich vorkommt als andere Elemente, die in dem Kontaktbereich enthalten sind.

Im Rahmen der Erfindung kann der Kontaktbereich, der ein unedles Metall aufweist, darüber hinaus auch andere Elemente, insbesondere auch edle Metalle aufweisen.

Enthält der Kontaktbereich, der ein unedles Metall aufweist, eine Legierung, die wenigstens ein Element ausgewählt aus Kupfer, Aluminium, Zink und Nickel aufweist, so kann es sich bei der Legierung beispielsweise um eine Legierung handeln, die im Wesentlichen aus Kupfer, Nickel, Zink und üblichen Verunreinigungen besteht, oder um eine Legierung, die im Wesentlichen aus Zinn, Gold und üblichen Verunreinigungen besteht.

In einem ersten Schritt des erfindungsgemäßen Verfahrens werden ein Substrat mit einem ersten Kontaktbereich und ein elektronisches Bauelement mit einem zweiten Kontaktbereich bereitgestellt, wobei wenigstens einer dieser Kontaktbereiche ein unedles Metall enthält.

Demnach kann entweder der Kontaktbereich des Substrats, der Kontaktbereich des elektronischen Bauelements oder der Kontaktbereich des Substrats und der Kontaktbereich des elektronischen Bauelements ein unedles Metall enthalten.

Definitionsgemäß weist das Substrat einen ersten Kontaktbereich und das elektronische Bauelement einen zweiten Kontaktbereich auf. Darüber hinaus kann das Substrat oder das elektronische Bauelement gegebenenfalls weitere Kontaktbereiche aufweisen. Wird als Substrat beispielsweise ein *Leadframe* verwendet, so enthält dieser *Leadframe* üblicherweise eine Vielzahl von (nebeneinanderliegenden) Kontaktbereichen, die zum Verbinden mit einer Vielzahl an elektronischen Bauelementen vorgesehen sind, um eine Baugruppe zu bilden.

In einem nächsten Schritt des erfindungsgemäßen Verfahrens wird eine Paste zur Verfügung gestellt, wie sie vorstehend definiert ist.

Diese Paste enthält daher (a) Metallpartikel, (b) wenigstens einen Aktivator, der wenigstens zwei Carbonsäure-Einheiten im Molekül trägt, und (c) ein Dispersionsmedium.

In einem weiteren Schritt des erfindungsgemäßen Verfahrens wird ein Aufbau erzeugt.

Dieser Aufbau enthält wenigstens das Substrat, das elektronische Bauelement und die Paste. Die Paste befindet sich dabei zwischen dem ersten Kontaktbereich des Substrats und dem ersten Kontaktbereich des elektronischen Bauelements. Demnach steht die erste Oberfläche des Substrats mit der zweiten Oberfläche des elektronischen Bauelements über die Paste in Kontakt.

Der Aufbau kann beispielsweise dadurch erzeugt werden, dass die Paste auf die Kontaktfläche des ersten Kontaktbereichs des Substrats appliziert und auf die applizierte Paste das elektronische Bauelement mit der Kontaktfläche des zweiten Kontaktbereichs gesetzt wird. Gleichermaßen kann der Aufbau auch dadurch erzeugt werden, dass die Paste auf die Kontaktfläche des zweiten Kontaktbereichs des elektronischen Bauelements appliziert und auf die applizierte Paste das Substrat mit der Kontaktfläche des ersten Kontaktbereichs gesetzt wird. Das Applizieren der Paste kann vorzugsweise mit fachüblichen Auftragetechniken, wie zum Beispiel mittels Druckverfahren (zum Beispiel Siebdruck oder Schablonendruck), Dispenstechnik, Spraytechnik, Pintransfer oder Dippen, erfolgen.

Der Abstand zwischen der ersten Oberfläche des Substrats und der zweiten Oberfläche des elektronischen Bauelements, der im Wesentlichen durch die Dicke der Paste bestimmt ist, liegt unmittelbar nach dem Erzeugen des Aufbaus vorzugsweise im Bereich von 20 - 200 µm und mehr bevorzugt im Bereich von 50-100 µm.

Nach der Erzeugung des Aufbaus kann dieser gegebenenfalls getrocknet werden. Die Trocknung des Aufbaus wird vorzugsweise bei einer Temperatur im Bereich von 80 - 200°C und mehr bevorzugt bei einer Temperatur im Bereich von 100 -150°C durchgeführt. Die Trocknung erfolgt vorzugsweise für einen Zeitraum von 2 - 20 Minuten und mehr bevorzugt für einen Zeitraum von 5 - 10 Minuten. Eine Trocknung kann, falls gewünscht, stattdessen oder darüber hinaus und vorzugsweise unter den vorstehenden Bedingungen auch erfolgen, während der Aufbau erzeugt wird, so zum Beispiel, bevor auf die auf das Substrat applizierte Paste das elektronische Bauelement oder bevor auf die auf das elektronische Bauelement applizierte Paste das Substrat gesetzt wird.

In einem weiteren Schritt des erfindungsgemäßen Verfahrens wird der Aufbau, der das Substrat, das elektronische Bauelement und die Paste enthält, gesintert.

Beim Sintern kommt es zum Verbacken der in der Paste enthaltenen Metallpartikel und wenigstens Teilen der Kontaktbereiche. Die übrigen in der Paste enthaltenen Bestandteile werden bei diesem Vorgang üblicherweise aus der Paste entfernt, indem sie beispielsweise, gegebenenfalls nach vorheriger chemischer Umsetzung, abgedampft werden. Das Sintern erfolgt aufgrund von Diffusionsprozessen, wobei Elemente, die in den Metallpartikeln der Paste enthalten sind, in die Kontaktbereiche diffundieren und Elemente, die in den Kontaktbereichen enthalten sind, in die Zwischenräume diffundieren, die von den Metallpartikeln der Paste gebildet werden. Aufgrund der bei diesem Vorgang vorherrschenden Temperaturen und Diffusionsgeschwindigkeiten kommt es zum Ausbilden einer stabilen stoffschlüssigen Verbindung.

Das Sintern des Aufbaus erfolgt vorzugsweise durch Erhitzen auf eine Temperatur von wenigstens 150°C, mehr bevorzugt auf eine Temperatur von wenigstens 175°C und noch mehr bevorzugt auf eine Temperatur von wenigstens 200°C. Vorzugsweise erfolgt das Sintern des Aufbaus durch Erhitzen auf eine Temperatur von nicht mehr als 350°C und mehr bevorzugt auf eine Temperatur von nicht mehr als 300°C. Demnach erfolgt das Erhitzen des Aufbaus vorzugsweise auf eine Temperatur im Bereich von 150 - 350°C, mehr bevorzugt auf eine Temperatur im Bereich von 150°C - 300°C, noch mehr bevorzugt auf eine Temperatur im Bereich von 175°C - 300°C und besonders bevorzugt auf eine Temperatur im Bereich von 200°C - 300°C.

Das Erhitzen erfolgt vorzugsweise ohne jegliche Anwendung von Prozessdruck, also bei einem Prozessdruck von 0 kbar, kann aber auch bei erhöhtem Prozessdruck, so zum Beispiel bei einem Prozessdruck von 1 kbar oder mehr durchgeführt werden.

Das Erhitzen kann vorzugsweise für eine Zeitdauer von 1 - 60 Minuten und mehr bevorzugt für eine Zeitdauer von 2 - 45 Minuten erfolgen.

Die Atmosphäre, in der das Erhitzen erfolgt, ist nicht weiter eingeschränkt. Vorzugsweise wird das Erhitzen jedoch in einer Atmosphäre durchgeführt, die Sauerstoff enthält.

Das Sintern wird in einer fachüblichen, zum Sintern geeigneten Vorrichtung durchgeführt, in der sich vorzugsweise die vorstehend beschriebenen Prozessparameter einstellen lassen.

Nach dem Sintern wird ein Modul enthalten, das wenigstens das Substrat und das elektronische Bauelement aufweist, die über die gesinterte Paste miteinander verbunden sind.

Gemäß einer besonders bevorzugten Ausführungsform wird das erfindungsgemäße Verfahren zum Verbinden wenigstens eines elektronischen Bauelements mit wenigstens einem Substrat über Kontaktbereiche durchgeführt, wobei wenigstens einer dieser Kontaktbereiche als unedles Metall Kupfer enthält. In diesem Fall hat es sich als besonders vorteilhaft erwiesen, eine Paste zu verwenden, die (a) Metallpartikel, (b) als Aktivator wenigstens eine Verbindung, die aus der Gruppe ausgewählt ist, die aus Malonsäure, Maleinsäure und Oxalsäure besteht, und (c) ein Dispersionsmedium enthält.

Gemäß einer weiteren besonders bevorzugten Ausführungsform wird das erfindungsgemäße Verfahren zum Verbinden wenigstens eines elektronischen Bauelements mit wenigstens einem Substrat über Kontaktbereiche durchgeführt, wobei wenigstens einer dieser Kontaktbereiche als unedles Metall Nickel enthält. In diesem Fall hat es sich als besonders vorteilhaft erwiesen, eine Paste zu verwenden, die (a) Metallpartikel, (b) als Aktivator wenigstens eine Verbindung, die aus der Gruppe ausgewählt ist, die aus Dimethylmalonsäure und Oxalsäure besteht, und (c) ein Dispersionsmedium enthält.

Die Erfindung wird im Folgenden anhand von Beispielen erläutert, die den Schutzbereich nicht einschränken.

### BEISPIELE:

Es wurden erfindungsgemäße Pasten 1 - 3 und Vergleichspasten 1 - 3 mit einer Zusammensetzung gemäß der nachstehenden Tabelle 1 wie folgt hergestellt:

**Tabelle 1: Zusammensetzung der Pasten 1 - 3 und der Vergleichspasten 1 - 3.**

| | **Paste 1** | **Paste 2** | **Paste** 3 | **Vergleichspaste 1** | **Vergleichspaste 2** | **Vergleichspaste 3** |
|---|---|---|---|---|---|---|
| **Silberpartikel** | 85 Gew.% | 85 Gew.% | 85 Gew.% | 85 Gew.% | 85 Gew.% | 85 Gew.% |
| **Paraffin** | 12 Gew.% | 12 Gew.% | 12 Gew.% | 12 Gew.% | 12 Gew.% | 12 Gew.% |
| ***Aktivator:*** | | | | | | |
| **Malonsäure** | 3 Gew.% | - | - | - | - | - |
| **Maleinsäure** | - | 3 Gew.% | - | - | - | - |
| **Dimethylmalonsäure** | - | - | 3 Gew.% | - | - | - |
| **Silberlactat** | - | - | - | 3 Gew.% | - | - |
| **Propionsäure** | - | - | - | - | 3 Gew.% | - |
| **Harnstoff** | - | - | - | - | - | 3 Gew.% |

In sechs unterschiedlichen Ansätzen (für Pasten 1 - 3 und Vergleichspasten 1 - 3) wurden die jeweiligen Aktivatoren zunächst in einer Kaffeemühle fein gemahlen und danach dem Dispersionsmedium zugesetzt. Mit Hilfe eines Ultraturaxmischers wurden aus diesen Mischungen homogene Suspensionen hergestellt. Diese homogenen Suspensionen wurden anschließend dem Silberpulver zugegeben. Die erhaltenen Mischungen wurden zunächst mit einem Spatel manuell homogenisiert, danach dreimal über einen Walzenstuhl gegeben und nochmals homogenisiert, um die Pasten 1 - 3 und die Vergleichspasten 1 - 3 zu erhalten.

Die Pasten 1 - 3 und die Vergleichspasten 1 - 3 wurden zum Verbinden von *Leadframes* mit Halbleiterchips eingesetzt.

Hierzu wurden *Leadframes* aus Kupfer oder Nickel und Halbleiterchips mit einer Silber-Metallisierung verwendet.

In sechs Ansätzen wurden die Pasten 1 - 3 und die Vergleichspasten 1 - 3 auf die jeweiligen *Leadframes* aufgetragen. Danach wurden die Halbleiterchips auf die aufgetragene Paste gesetzt. Der Abstand zwischen den sich gegenüberliegenden Oberflächen von *Leadframe* und Halbleiterchip betrug 80 µm. Der erhaltene Aufbau wurde bei einer Temperatur von 150°C für 5 Minuten vorgetrocknet. Anschließend wurde der erhaltene Aufbau drucklos bei einer Temperatur von 250°C gesintert.

Nach dem Sinterprozess wurde eine Auswertung im Hinblick auf das Vorhandensein einer Verbindung zwischen Halbleiterchip und *Leadframe* sowie die Zuverlässigkeit dieser Verbindung vorgenommen.

Die Ergebnisse dieser Auswertung sind in Tabelle 2 zusammengefasst.

**Tabelle 2: Ergebnisse der Untersuchungen mit den Pasten 1 - 3 und den Vergleichspasten 1 - 3.**

| | **Unedles Metall des Kontaktbereichs** | **Verbindung zwischen Halbleiterchip und Leadframe** | **Zuverlässigkeit der Verbindung** |
|---|---|---|---|
| **Paste 1** | Kupfer | Stabile Verbindung | Sehr hoch |
| **Paste 2** | Kupfer | Stabile Verbindung | Sehr hoch |
| **Paste 3** | Nickel | Stabile Verbindung | Sehr hoch |
| **Vergleichspaste 1** | Kupfer | Keine Verbindung, Halbleiterchip haftet nicht an Leadframe an | - |
| **Vergleichspaste** 2 | Kupfer | Keine Verbindung, Halbleiterchip haftet nicht an Leadframe an | - |
| **Vergleichspaste** 3 | Nickel | Keine Verbindung, Halbleiterchip haftet nicht an Leadframe an | - |

Die Versuche zeigen, dass die Ausbildung einer stabilen Verbindung nur bei Verwendung der erfindungsgemäßen Pasten 1 - 3, nicht jedoch bei Verwendung der Vergleichspasten 1 - 3 erreicht werden kann.

## Patentansprüche

1. Sinterpaste enthaltend
(a) Metallpartikel, die ausgewählt sind aus der Gruppe bestehend aus Kupfer-, Silber-, Nickel- und Aluminiumpartikeln,
(b) wenigstens einen Aktivator, der wenigstens zwei Carbonsäure-Einheiten im Molekül trägt, und
(c) ein Dispersionsmedium.

2. Paste nach Anspruch 1, **dadurch gekennzeichnet, dass** die Metallpartikel Silberpartikel sind.

3. Paste nach Anspruch 1 oder 2, **dadurch gekennzeichnet, dass** der Aktivator einen Zersetzungspunkt im Bereich von 100 - 300°C aufweist.

4. Paste nach einem der Ansprüche 1 - 3, **dadurch gekennzeichnet, dass** der Aktivator aus der Gruppe ausgewählt ist, die aus Dicarbonsäuren und komplexierten Dicarbonsäuren besteht.

5. Paste nach einem der Ansprüche 1 - 4, **dadurch gekennzeichnet, dass** der Aktivator aus der Gruppe ausgewählt ist, die aus Malonsäure, Maleinsäure, Dimethylmalonsäure und Oxalsäure besteht.

6. Paste nach einem der Ansprüche 1 - 5, **dadurch gekennzeichnet, dass** das Dispersionsmedium eine aliphatische Kohlenwasserstoffverbindung enthält.

7. Verfahren zum Verbinden wenigstens eines elektronischen Bauelements mit wenigstens einem Substrat über Kontaktbereiche, wobei wenigstens einer dieser Kontaktbereiche ein unedles Metall enthält, umfassend die Schritte:
(i) Bereitstellen eines Substrats mit einem ersten Kontaktbereich und eines elektronischen Bauelements mit einem zweiten Kontaktbereich, wobei wenigstens einer dieser Kontaktbereiche ein unedles Metall enthält,
(ii) Bereitstellen einer Paste enthaltend
(a) Metallpartikel, die ausgewählt sind aus der Gruppe bestehend aus Kupfer-, Silber-, Nickel- und Aluminiumpartikeln
(b) wenigstens einen Aktivator, der wenigstens zwei Carbonsäure-Einheiten im Molekül trägt, und
(c) ein Dispersionsmedium,
(iii) Erzeugen eines Aufbaus, wobei der erste Kontaktbereich des Substrats mit dem zweiten Kontaktbereich des elektronischen Bauelements über die Paste in Kontakt steht und
(iv) Sintern des Aufbaus unter Herstellung eines Moduls, das wenigstens das Substrat und das elektronische Bauelement aufweist, die über die gesinterte Paste miteinander verbunden sind.

8. Verfahren nach Anspruch 7, **dadurch gekennzeichnet, dass** wenigstens einer der Kontaktbereiche integraler Bestandteil des elektronischen Bauelements oder des Substrats ist.

9. Verfahren nach Anspruch 7 oder 8, **dadurch gekennzeichnet, dass** das unedle Metall Kupfer ist und der Aktivator aus der Gruppe ausgewählt ist, die aus Malonsäure, Maleinsäure und Oxalsäure besteht.

10. Verfahren nach Anspruch 7 oder 8, **dadurch gekennzeichnet, dass** das unedle Metall Nickel ist und der Aktivator aus der Gruppe ausgewählt ist, die aus Dimethylmalonsäure und Oxalsäure besteht.

## Claims

1. Sinter paste containing
(a) metal particles, selected from the group consisting of copper, silver, nickel and aluminium particles
(b) at least one activator that bears at least two carboxylic acid units in the molecule; and
(c) a dispersion medium.

2. Paste according to claim 1, **characterised in that** the metal particles are silver particles.

3. Paste according to claim 1 or 2, **characterised in that** the activator has a decomposition point in the range of 100 - 300°C.

4. Paste according to any one of the claims 1 - 3, **characterised in that** the activator is selected from the group consisting of dicarboxylic acids and complexed dicarboxylic acids.

5. Paste according to any one of the claims 1 - 4, **characterised in that** the activator is selected from the group consisting of malonic acid, maleic acid, dimethylmalonic acid, and oxalic acid.

6. Paste according to any one of the claims 1 - 5, **characterised in that** the dispersion medium contains an aliphatic hydrocarbon compound.

7. Method for connecting at least one electronic component to at least one substrate through contact regions, whereby at least one of said contact regions contains a non-noble metal, comprising the steps:
(i) providing a substrate having a first contact region and an electronic component having a second contact region, whereby at least one of said contact regions contains a non-noble metal;
(ii) providing a paste containing
(a) metal particles, selected from the group consisting of copper, silver, nickel and aluminium particles
(b) at least one activator that bears at least two carboxylic acid units in the molecule; and
(c) a dispersion medium;
(iii) generating a structure, whereby the first contact region of the substrate contacts the second contact region of the electronic component through the paste; and
(iv) sintering the structure while producing a module that comprises at least the substrate and the electronic component connected to each other through the sintered paste.

8. Method according to claim 7, **characterised in that** at least one of said contact regions is an integral component of the electronic component or of the substrate.

9. Method according to claim 7 or 8, **characterised in that** the non-noble metal is copper and the activator is selected from the group consisting of malonic acid, maleic acid, and oxalic acid.

10. Method according to claim 7 or 8, **characterised in that** the non-noble metal is nickel and the activator is selected from the group consisting of dimethylmalonic acid and oxalic acid.

## Revendications

1. Pâte frittée contenant
(a) des particules métalliques qui sont sélectionnées parmi le groupe constitué de particules de cuivre, d'argent, de nickel et d'aluminium,
(b) au moins un activateur qui porte au moins deux fragments d'acide carboxylique dans la molécule, et
(c) un milieu de dispersion.

2. Pâte selon la revendication 1, **caractérisée en ce que** les particules métalliques sont des particules d'argent.

3. Pâte selon la revendication 1 ou 2, **caractérisée en ce que** l'activateur présente un point de décomposition dans la plage de 100 à 300°C.

4. Pâte selon une des revendications 1 à 3, **caractérisée en ce que** l'activateur est sélectionné parmi le groupe qui se compose d'acides dicarboxyliques et d'acides dicarboxyliques complexés.

5. Pâte selon une des revendications 1 à 4, **caractérisée en ce que** l'activateur est sélectionné parmi le groupe qui se compose de l'acide malonique, l'acide maléique, l'acide diméthylmalonique et l'acide oxalique.

6. Pâte selon une des revendications 1 à 5, **caractérisée en ce que** le milieu de dispersion contient un composé d'hydrocarbure aliphatique.

7. Procédé de connexion d'au moins un composant électronique à au moins un substrat par le biais de zones de contact, dans lequel au moins une de ces zones de contact contient un métal commun, comprenant les étapes :
(i) mise à disposition d'un substrat avec une première zone de contact et d'un composant électronique avec une seconde zone de contact, dans lequel au moins une de ces zones de contact contient un métal commun,
(ii) mise à disposition d'une pâte contenant
(a) des particules métalliques qui sont sélectionnées parmi le groupe constitué de particules de cuivre, d'argent, de nickel et d'aluminium,
(b) au moins un activateur qui porte au moins deux fragments d'acide carboxylique dans la molécule, et
(c) un milieu de dispersion,
(iii) génération d'une structure, dans lequel la première zone de contact du substrat est en contact avec la seconde zone de contact du composant électronique par le biais de la pâte et
(iv) frittage de la structure en fabriquant un module qui présente au moins le substrat et le composant électronique qui sont reliés ensemble par le biais de la pâte frittée.

8. Procédé selon la revendication 7, **caractérisé en ce qu'**au moins une des zones de contact fait partie intégrante du composant électronique ou du substrat.

9. Procédé selon la revendication 7 ou 8, **caractérisé en ce que** le métal commun est le cuivre et l'activateur est sélectionné parmi le groupe qui se compose de l'acide malonique, l'acide maléique et l'acide oxalique.

10. Procédé selon la revendication 7 ou 8, **caractérisé en ce que** le métal commun est le nickel et l'activateur est sélectionné parmi le groupe qui se compose de l'acide diméthylmalonique et l'acide oxalique.
